## Europäisches Patentamt
## European Patent Office
## Office européen des brevets

(19)

(11) Publication number: **0 037 268**
**A1**

(12) **EUROPEAN PATENT APPLICATION**

(21) Application number: **81301339.8**

(22) Date of filing: **27.03.81**

(51) Int. Cl.³: **H 03 K 17/16**
**H 03 K 17/56**

(30) Priority: **29.03.80 JP 41836/80 U**

(43) Date of publication of application:
**07.10.81 Bulletin 81/40**

(84) Designated Contracting States:
**DE FR GB NL**

(71) Applicant: **VICTOR COMPANY OF JAPAN, LIMITED**
**3-12, Moriya-cho**
**Kanagawa-ku Yokohama(JP)**

(72) Inventor: **Toyomaki, Kazuya**
**c/o Victor Company of Japan Limited**
**3-12, Moriya-cho Kanagawa-ku Yokohama(JP)**

(74) Representative: **Senior, Alan Murray et al,**
**J.A. KEMP & CO 14 South Square Gray's Inn**
**London WC1R 5EU(GB)**

(54) **Switching circuit for effecting selection from a plurality of input analog signals.**

(57) A switching circuit for effecting selection from a plurality of input analog signals comprises a voltage amplifier (Av) selectively responsive to one of the input analog signals, a plurality of series circuits of two resistors (Ra1, Rb1; Ra2, Rb2) each of which series circuits is interposed between each of the input terminals (IN1, IN2) and an output terminal (OUT) of the voltage amplifier (Av) and a plurality of semiconductor switching elements (S1, S2) respectively interposed between junctions connecting the two resistors (Ra1, Rb resp. Ra2, Rb2) of respective series circuits and an inverting input terminal of the voltage amplifier (Av) while a noninverting input terminal of the same is grounded. With this arrangement, only a negligibly small amount of current flows via each of the switching element (S1, S2) in on-state thereof so that distortion due to the variation in on-state resistance of the switching element (S1, S2) can be ignored, while switching noise is suppressed because the switching elements are used at an imaginal short point of the voltage amplifier (Av). Auxiliary switching elements may be provided for preventing crosstalk between different channel signals.

FIG. 4

0037268

## TITLE

## SWITCHING CIRCUIT FOR EFFECTING SELECTION

## FROM A PLURALITY OF INPUT ANALOG SIGNALS

### FIELD OF THE INVENTION

This invention generally relates to a switching circuit for effecting selection from a plurality of input analog signals, and more particularly, the present invention relates to such a circuit in which semiconductor switching elements, such as FETs, are used as switching elements.

### BACKGROUND OF THE INVENTION

Various types of signal switching circuits for effecting selection and changeover of a plurality of analog signals are known. For instance, there is one which has transistors as switching elements, one which has field effect transistors (which will be referred to as FETs hereinbelow), and the like. Among such conventional signal switching circuits, one having FETs as analog switches have been considered superior in view of switching time, switching noise, durability and others.

Among FETs, MOS FETs are advantageous because gate leak is small, and furthermore, enhancement-type FETs are superior because the control voltage thereof can be increased up to positive and negative source voltages because of no fear of forward bias, so that its drive circuit may be simple in construction, while the dynamic range in the form of voltage can be made large. Especially, in recent days, since monolithic ICs, in which a drive circuit is also incorporated in the same chip, are available, application of MOS FETs offers great advantages. However, MOS FETs are expensive, and since the operational time delay is relatively great, MOS FETs are difficult to perform high-speed operations, while the degree of switching noise is relatively high because of leakage components of its control signal due to stray capacitance. Therefore, it has been desired to provide a circuit arrangement for a signal switching circuit which is capable of obtaining a sufficiently large dynamic range, providing less distortion, by using inexpensive junction FETs.

To make matters worse, when using junction FETs, there are two problems to be solved. The first problem is that when an FET is used in on-state with its gate voltage fixed, for passing therethrough an input signal having a voltage within a limited small range, the voltage VGS between gate and source (or the voltage VGD between gate and drain) of the FET varies by the signal voltage, and therefore, on-state resistance varies to cause the signal to produce distortion; and that because of voltage caused by a current flowing through the FET, the voltage VGS

between gate and source (or the voltage VGD between gate and drain) varies to change on-state resistance so that distortion occurs in the signal. The second problem is that it is necessary to put the gate in floating condition (for preventing forward bias current) in on-state in order to make the dynamic range large in the case that the voltage range of the input signal is great.

## SUMMARY OF THE INVENTION

The present invention has been developed in order to remove the above-mentioned disadvantages and drawbacks inherent to the conventional circuit arrangements for an analog signal switching circuit.

It is, therefore, an object of the present invention to provide a switching circuit for effecting selection from a plurality of input analog signals, where undesirable distortion and switching noise hardly occur, while semiconductor switching elements used in the circuit can be readily driven, providing high-speed switching operation.

According to a feature of the present invention the swtiching circuit is arranged such that all the semiconductor switching elements perform on-off operations at an imaginal short point of a voltage amplifier, so that the potentials of respective signals passing through the swtiching elements are close to ground potential, while the variation range of the potential is small.

According to another feature of the present invention the input impedance of the voltage amplifier can be considerably great, so that only negligibly small amount of currents flow via respective switching elements in on-state thereof, so that distortion due to the variation in resistance of the switching elements in on-state is negligibly small.

In accordance with the present invention, there is provided a switching circuit for effecting selection from a plurality of input analog signals, comprising: (a) a plurality of input terminals for receiving said plurality of input analog signals; (b) a voltage amplifier having an inverting input terminal, a noninverting input terminal connected to ground, and an output terminal connected to an output terminal of said switching circuit; (c) a plurality of series circuits, each having two resistors, each of said series circuits being interposed between each of said input terminals of said switching circuit and said output terminal of said voltage amplifier; and (d) a plurality of switches respectively interposed between junctions connecting said two resistors of each of said series circuits, and said inverting input terminal of said voltage amplifier.

## BRIEF DESCRIPTION OF THE DRAWINGS

The object and features of the present invention will become more readily apparent from the following detailed description of the embodiments of the invention taken in conjunction with the accompanying drawings in which:

Figs. 1 and 2 are circuit diagrams of conventional signal switching circuits;

Fig. 3 is a circuit diagram of a conventional circuit arrangement for actualizing gate-floating condition for an FET used as a switching element in the conventional circuits; and

Figs. 4 and 5 are respectively circuit diagrams of embodiments of the switching circuits according to the present invention.

## DETAILED DESCRIPTION OF THE PREFERRED EMBODIMENTS

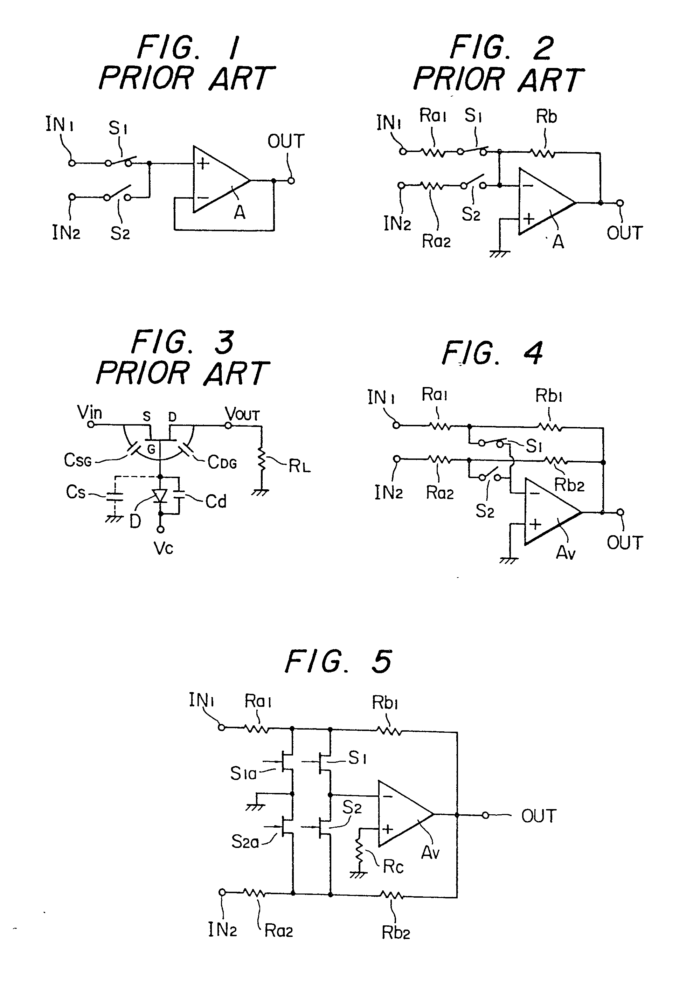

Prior to describing the embodiments of the present invention, some conventional circuit arrangements for switching circuits will be discussed with reference to Fig. 1 and 2 for a better understanding of the object and features of the present invention.

Fig. 1 and Fig. 2 show examples of conventional arrangements of signal switching circuits. In the circuit arrangement of Fig. 1, a noninverting input terminal of an amplifier A is connected to a plurality of input terminals IN1 and IN2 respectively, and an inverting input terminal and an output terminal of the amplifier A are connected to each other so as to constitute a signal switching circuit. Meanwhile, the input impedance of the amplifier A can be made high. Accordingly, currents hardly flow through switches S1 and S2 in on-state of the switches S1 and S2 so that when FETs are used as the switches S1 and S2, occurrence of distortion due to the variation in on-state resistance can be ignored. However, in order to provide an adequate dynamic range in the case of a great input signal voltage, and to block forward bias current, it is necessary to put the gate of the FET in floating condition in on-state.

Fig. 3 is a circuit diagram showing a coventional circuit arrangement for putting the gate of the FET in floating condition. In Fig. 3, a reference D is a diode; and RL, a load resistor. In the circuit of Fig. 3, when a control voltage Vc is swung to a positive source voltage in on-state, forward bias current to the gate of the FET is blocked by the diode D so that the gate of FET is put in floating condition.

However, as is well known, there are stray capacitances CSG and CDG, while there is another stray capacitance CS between peripheral parts and the substrate. Since these capacitances have been charged nearly up to the negative source voltage in off-state of the switch, the gate voltage, which is obtained by dividing the control voltage Vc by the capacitance Cd of the diode D and the sum (CS + CSG + CDG) of the above-mentioned stray capacitances, cannot put the FET in on-state with its gate voltage maintained at a negative value if the capacitance Cd of the diode D is small even though the control voltage Vc has varied to the positive source voltage.

Therefore, it is usually practiced to connect a capacitor (not shown) having a suitable capacitance in parallel with the diode D. However, in the case that a capacitor is connected in parallel with the diode D in this manner, a small forward current flows through the gate at the instant when the FET turns on, and therefore, a problem of swithcing noise (leakage of control signal) will arise. Especially, this switching noise cannot be ignored in the case of high-speed switching..

The signal switching circuit of the conventional arrangement of Fig. 2, is constructed such that a resistor Rb is connected between an inverting input terminal of an amplifier A, whose noninverting input terminal is grounded, and an output terminal of the signal switching circuit; and between a plurality of input terminals IN1 and IN2 and the inverting input terminal of the amplifier A are respectively, connected a series circuit of a resistor Ra1 and a switch S1, and a seires circuit of a resistor Ra2 and a switch S2. In the signal switching circuit shown in Fig. 2, since the switching operations of the switches S1 and S2 are performed at an imaginarily grounded point (imaginal short point), the range of voltage applied to the switches S1 and S2 in on-state is small, and accordingly, the gate of FETs, which are used as the switches S1 and S2, may be fixed at a given potential (for instance, ground potential) without putting the same in floating condition. However, as described in the above, because of the variation of the voltage drop which occurs by the current flowing through the FETs, distortion will occur in the signal. In addition, when putting in gate-floating condition in order to reduce the distortion due to the variation of the voltage drop, a problem of switching noise will arise as mentioned in the above.

The present invention has been developed with the purpose of providing a signal switching circuit in which simple switching elements, such as junction FETs, can be used; the swithcing elements can be readily driven; and distortion is low. Detailed contents of the signal switching circuit according to the present invention will be described with reference to the accompanying drawings hereinbelow.

Fig. 4 is a circuit diagram showing the constructional principle and also an embodiment of the signal switching circuit according to the present invention, and in Fig. 4, references IN1 and IN2 are signal input terminals; OUT, a signal output terminal; and Av, a voltage amplifier.

. Between the input terminal IN1 and the output terminal OUT is connected a series circuit of a resistor Ra1 and a resistor Rb1, while between the input terminal IN2 and the output terminal OUT is connected a seires circuit of a resistor Ra2 and a resistor Rb2. Between a junction point connecting the resistors Ra1 and Rb1, and a noninverting input terminal of the voltage amplifier Av is connected a switch S1, while between a junction point connecting the resistors Ra2 and Rb2, and the noninverting input terminal of the voltage amplifier Av is connected another switch S2.

In Fig. 4, although only two input terminals IN1 and IN2 are shwon to be provided, in the case that a plurality (n) of input terminals IN1, IN2 ... INn are provided, a plurality of series circuits of two resistors Rai and Rbi (wherein i is from 1 to n) may be provided between respective input terminals and the output terminal OUT, and also respective junction points of the above-mentioned series circuit of two resistors may be respectively connected via swtiches Si (wherein i is from l to n) to the inverting input terminal of the voltage amplifier Av.

The noninverting input terminal of the voltage amplifier Av is grounded, while the output terminal of the voltage amplifier Av is connected to the output terminal OUT of the switching circuit.

In the signal switching circuit constructed as shown in Fig. 4, since the switching operations of the switches S1 and S2 are performed at an imaginarily grounded point of the voltage amplifier Av, the potential of the signals passing though the switches S1 and S2 is close to the ground potential, while its variation range is small. In addition, since the input impedance of the voltage amplifier can be made great readily, currents hardly flow through the switches S1 and S2 in on-state, and therefore, the degree of distortion due to the variation in on-state resistances of the switches S1 and S2 is very small, and it is possible to reduce the distortion to an extent that the distortion is negligible. Accordingly, there would be no problem even if junction FETs are used as the switches S1 and S2, and thus the way of driving the FETs is easy, while switching noise can be made small because the gate potential of the FETs used as the

switches S1 and S2 may be fixed to a given potential, such as a value close to the ground potential.

In the circuit arrangement of Fig. 4, if the amplification degree of the voltage amplifier Av is sufficiently great, the signal from the input terminal IN1 is multiplied by $-Rb1/Ra1$ to be emitted when the switch S1 is in on-state, and the signal from the input terminal IN2 is multiplied by $-Rb2/Ra2$ to be emitted when the switch S2 is in on-state, so that selection and changeover of signals are effected.

Fig. 5 is a circuit diagram of another embodiment of the signal switching circuit according to the present invention , and in the drawing, references S1, S2, S1a and S2a are N-channel junction FETs. When selecting the signal from the input terminal IN1, the FET S1 and the FET S2a are respectively put in on-state by making the gates thereof assume ground potential, while the FET S2 and the FET S1a are respectively put in off-state by making the potential of the gates thereof equal to or lower than a negative pinchoff voltage. When selecting the signal from the input terminal IN2, the potentials of the respective gates may be made opposite to the above-mentioned case. The FETs S1a and S2a are provided for reducing or preventing crosstalk between different channel signals, while a reference Rc is a resistor interposed between the noninverting input terminal of the voltage amplifier Av and ground. The resistor Rc is employed as a balancing resistor as is well known in operational amplifier technique, and this resistor Rc may be omitted if unnecessary, while similar resistor may be employed in the arrangement of Fig. 4 if desired. In the embodiment of Fig. 5, although N-channel FETs are used, it is a matter of course that P-channel FETs may be used with the polarity of the control signal reversed. Although no drive circuit for the FETs S1, S2, S1a and S2a is shown, suitable switching transistors may be provided for causing the respective FETs to become conductive and nonconductive. Therefore, the circuit arrangement of Fig. 3, i.e. the parallel circuit of the diode D and the above-mentioned additional capacitor, for providing gate-floating condition is not required.

From the foregoing description, it will be apparent that a signal switching circuit, which hardly produces distortion or switching noise with high-speed switching operation and easy driving of the switches, can be readily provided according to the present invention. Moreover, since occurrence of distortion has been extremely suppressed in the circuit of the present invention, a signal switching circuit having superior characteristics compared to the conventional circuits may be constructed even though MOS FETs are used as switching elements.

The above-described embodiments are just examples of the present invention, and therefore, it will be understood for those skilled in the art that many modifications and variations may be made without departing from the spirit of the present invention.

## CLAIMS

1. A switching circuit for effecting selection from a plurality of input analog signals, comprising:

(a) a plurality of input terminals for receiving said plurality of input analog signals;

(b) a voltage amplifier having an inverting input terminal, a noninverting input terminal connected to ground, and an output terminal connected to an output terminal of said switching circuit;

(c) a plurality of series circuits, each having two resistors, each of said series circuits being interposed between each of said input terminals of said switching circuit and said output terminal of said voltage amplifier; and

(d) a plurality of switches respectively interposed between junctions connecting said two resistors of each of said series circuits, and said inverting input terminal of said voltage amplifier.

2. A switching circuit as claimed in Claim 1, wherein each of said switches comprises a junction FET arranged to perform on-off operations in accordance with a control signal applied thereto.

3.     A switching circuit as claimed in Claim 1, further comprising auxiliary switches respectively interposed between said junctions and ground.

4.     A switching circuit as claimed in Claim 3, wherein said each of said auxiliary switches comprises a junction FET arranged to perform on-off operations in accordance with a control signal applied thereto.

5.     A switching circuit as claimed in Claim 1, wherein said voltage amplifier comprises an operational amplifier.

6.     A switching circuit as claimed in Claim 1, further comprising a resistor interposed between said noninverting input terminal of said voltage amplifier and ground so that said noninverting input terminal is grounded via said resistor.

FIG. 1
PRIOR ART

FIG. 2
PRIOR ART

FIG. 3
PRIOR ART

FIG. 4

FIG. 5

European Patent Office

**EUROPEAN SEARCH REPORT**

Application number

EP 81 30 1339.8

| | DOCUMENTS CONSIDERED TO·BE RELEVANT | | CLASSIFICATION OF THE APPLICATION (Int. Cl.³) |
|---|---|---|---|
| Category | Citation of document with indication, where appropriate, of relevant passages | Relevant to claim | |
| X | <u>US - A - 3 135 874</u> (P.G. LUCAS et al.)<br>* column 4, lines 18 to 45;<br>  fig. 2 *<br>-- | 1,5 | H 03 K   17/16<br>H 03 K   17/56 |
| | U. TIETZE· et al.   "Halbleiter-Schalt-<br>tungstechnik"<br>4th edition,<br>1978, SPRINGER-VERLAG, Berlin,<br>Heidelberg,New York<br>page 404<br>* section 17.3.1; fig. 17.13 *<br>-- | 1,5 | |
| | ELEKTRONIK, No. 17, 1979<br>B. MURRAY "Schalten analoger Signale<br>mit Halbleiterschaltern"<br>pages 49 to 52<br>* fig. 13 *<br>-- | 1,5 | TECHNICAL FIELDS SEARCHED (Int. Cl.³)<br><br>G 01 D   5/25<br>G 08 C   15/06<br>G 10 H   1/18<br>G 11 C   27/02<br>H 03 F   3/72<br>H 03 K   17/16<br>H 03 K   17/56 |
| A | EDN, Vol. 24, No. 2, January 1979<br>D. WILENKEN "Reduce CMOS- multiplexer<br>troubles through proper device<br>selection"<br>pages 75 to 79<br>* fig. 1 *<br>-- | 1 | H 04 J   3/04<br>H 04 Q   3/52 |
| A | <u>US - A - 3 449 688</u> (R.E. BROWN)<br>* column 3, line 9 to column 5,<br>  line 48; fig. 4 to 7 *<br>--<br>./.. | | CATEGORY OF CITED DOCUMENTS<br><br>X: particularly relevant<br>A: technological background<br>O: non-written disclosure  .<br>P: intermediate document<br>T: theory or principle underlying the invention<br>E: conflicting application<br>D: document cited in the application<br>L: citation for other reasons<br><br>&: member of the same patent family, corresponding document |

| | | | |
|---|---|---|---|
| X | The present search report has been drawn up for all claims | | |
| Place of search<br>Berlin | Date of completion of the search<br>15-06-1981 | Examiner<br>ARENDT | |

European Patent
Office

**EUROPEAN SEARCH REPORT**

## DOCUMENTS CONSIDERED TO BE RELEVANT

| Category | Citation of document with indication, where appropriate, of relevant passages | Relevant to claim |
|---|---|---|
| A | DD - A - 79 325 (G. HÖHNEL et al.) <br> * fig. 1 * <br> -- | |
| A | GB - A - 1 482 290 (HEWLETT-PACKARD LTD.) <br> -- | |
| A | H. RICHTER "Praxis der integrierten Schaltungen" <br> 1970, TELEKOSMOS-VERLAG FRANCKH'SCHE VERLAGSHANDLUNG, Stuttgart <br> pages 74 to 78 <br> * page 76, line 6 to page 77, line 26; <br> page 78, lines 13 to 19 * <br> ----- | |

**CLASSIFICATION OF THE APPLICATION (Int. Cl.³)**

**TECHNICAL FIELDS SEARCHED (Int. Cl.³)**

EPO Form 1503.2   06.78